# EUROPEAN PATENT APPLICATION

(11) **EP 2 487 493 A1**
(43) Date of publication of application: **15.08.2012**
(21) Application number: 10821641.7
(22) Date of filing: 29.09.2010
(51) Int. Cl.: G01R 11/56, G01R 22/00, G08C 15/00, G08C 19/00

(54) **ELECTRIC POWER METER**

(30) Priority: 05.10.2009 JP 2009232010
(71) Applicant: Panasonic Corporation, Kadoma-shi Osaka 571-8501 (JP)
(72) Inventor: KUNIYOSHI, Kenji, Osaka 571-8686 (JP)
(74) Representative: Samson & Partner
(86) International application number: PCT/IB2010/002476
(87) International publication number: WO 2011/042784

(57) **Abstract**

An electric power meter separately measures an amount of electric power for purchase supplied from an electric power system and an amount of electric power for sale which is generated by an electricity generation device. The electric power meter detects a power flow of the electric power system and separately measures the amount of electric power for purchase and the amount of electric power for sale while distinguishing between the amount of electric power for purchase and the amount of electric power for sale on the basis of a direction of the detected power flow.

## Description

### Field of the Invention

The present invention relates to an electric power meter which separately measures the amount of electric power for purchase and the amount of electric power for sale.

### Background of the Invention

With the recent proliferation of private power generation such as solar power generation, wind power generation, it has been proposed that for example, direct current (DC) power generated by photovoltaic power generation is converted to alternating current (AC) power by an inverter so that the converted AC power may be consumed by a household. Further, it has also been proposed that if the amount of the electric power generated by an electricity generation system such as a photovoltaic power station or the like exceeds the amount of the electric power consumed by the household (excess electric power generation), the excess electric power can be sold to a power supply company. To this end, an electric power meter for measuring the excess electric power for sale that is generated by a photovoltaic power system is first connected to a drop wire or service wire that is connected to the network of electricity supply, so as to measure the amount of electric power that flows to the electricity supply network. Then, the amount of electric power for sale is calculated based on the indications of the electric power meter, and a charge corresponding to the calculated amount of electric power is paid to a person (power seller) who owns the photovoltaic power system.

Generally, the amount of electric power for purchase or sale that is measured by an electric power meter for the purchase or sale of electric power is sent to a measuring center via a public data network by a remote-measurable electric power meter that was disclosed e.g. in Patent Document 1.
[Patent Document 1] Japanese Patent Application Publication No. 2005-70869

### Summary of the Invention

However, in order to obtain the amount of electric power to be purchased together with the amount of electric power to be sold, using such a remote-measurable electric power meter, there is a need to provide in parallel a dedicated electric power meter for measuring the amount of electric power for purchase and another dedicated one for electric power for sale. The amount of electric power for purchase or sale is the power information of merely one consumer, so that it is unreasonable for the electric power meters for the purchase and sale of electric power to be separately provided in order to obtain the power information of the respective consumer, and if this is done, wiring structures thereof essentially become complicated.

Accordingly, the present invention has been made keeping in mind the above problems occurring in the related art, and the present invention provides an electric power meter that is capable of reasonably measuring a plurality of pieces of power information about respective power consumers, that is, information about the amount of electric power for purchase or sale.

In accordance with an embodiment of the present invention, there is provided an electric power meter separately measuring an amount of electric power for purchase supplied from an electric power system and an amount of electric power for sale which is generated by an electricity generation device, wherein the electric power meter detects a power flow the electric power system and separately measures the amount of electric power for purchase and the amount of electric power for sale while distinguishing between the amount of electric power for purchase and the amount of electric power for sale on the basis of a direction of the detected power flow.

With such configuration, the electric power meter detects the flow of power in the electric power system and distinguishes between the amount of electric power for purchase and the amount of electric power for sale on the basis of the detected flow of power, so that it can be determined whether the electric power is power supplied from an electricity supply company to a power consumer or vice versa, based on the direction of flow of power input to the electric power meter. Because of this, the amount of electric power for purchase and the amount of electric power for sale are separately measured based on that determination, and the power information of respective power consumers about the amount of electric power for purchase and the amount of electric power for sale can be measured by a single electric power meter. Thus, the plurality of pieces of power information about respective power consumers, such as the amount of electric power for purchase and the amount of electric power for sale, can be reasonably measured by a single electric power meter.

Further, the electric power meter may be provided with a power display that displays the amount of electric power for purchase and the amount of electric power for sale, which were separately measured, in a discriminative manner.

With such configuration, the electric power meter is provided with a display that displays the amount of electric power for purchase and that for sale, which were separately measured, in a discriminative manner, when measuring the amount of electric power for purchase and that for sale using the unitary electric power meter, so that the unitary electric power meter can display two kinds of information, such as the amount of electric power for purchase and the amount of electric power for sale, in a discriminative manner. Thus, when configuring the unitary electric power meter that is capable of measuring both the amount of electric power for purchase and the amount of electric power for sale, the practicality can be improved properly.

Further, the power display may include two separate display units that consist of a display unit which displays the amount of electric power for purchase and a display unit which displays the amount of electric power for sale.

With such configuration, the power display includes two separate display units that consist of a power display unit for the amount of electric power for purchase and a power display unit for the amount of electric power for sale, the amount of electric power for purchase and the amount of electric power for sale can be physically distinguished between and separated. Thus, when configuring the unitary electric power meter that is capable of measuring both the amounts of electric power for purchase and for sale, it is easier to discriminate between the amount of electric power for purchase and that for sale.

Further, the power display may be composed of a single display screen having a common display section on which both the amount of electric power for purchase and the amount of electric power for sale are displayed in common.

With such configuration, the power display is composed of a single display screen having a common display section on which both the amount of electric power for purchase and the amount of electric power for sale are displayed in common. Thus, when displaying both the amount of electric power for purchase and the amount of electric power for sale in a discriminative manner using the electric power meter, the power display can be simplified.

Further, the common display section of the power display may display the amount of electric power for purchase and the amount of electric power for sale in a time-division manner.

With such configuration, the common display section of the power display displays both the amount of electric power for purchase and the amount of electric power for sale in a time-division manner. Thus, when displaying both the amount of electric power for purchase and the amount of electric power for sale on the common display section of the unitary power display, respective integrating values can be easily identified.

Further, the electric power meter may have a communication function of automatically transmitting the amount of electric power for purchase and the amount of electric power for sale, which were separately measured, to a measuring center that is a management center of the electric power meter, in such a manner as to alternately transmit information about both the amounts of electric power for purchase and for sale to the measuring center in sequence.

With such configuration, the amounts of electric power for purchase and for sale, which were separately measured, are alternately transmitted to the measuring center in sequence, so that the electric power meter can transmit respective power information including the amounts of electric power for purchase and for sale to the measuring center in a discriminative manner based on timing when the respective power information is transmitted, while having a single communication interface in common. Thus, when configuring the remotely measurable electric power meter that is capable of measuring both the amounts of electric power for purchase and for sale, the amounts of electric power for purchase and for sale for each power consumer can be managed with high reliability. Further, when it is configured such that the amounts of electric power for purchase and sale, which were separately measured, are alternately transmitted to the measuring center in sequence, both instant information about the purchased power and about sold power can be transmitted together to the measuring center.

Further, the electric power meter has a communication function of automatically transmitting the amount of electric power for purchase and the amount of electric power for sale, which were separately measured, to a measuring center that is a management center of the electric power meter, in such a manner as to selectively transmit to the measuring center a measured amount of electric power whenever determination is made whether the amount of electric power is for purchase or for sale.

With such configuration, a target amount of electric power to be measured is selectively transmitted to the measuring center according to the determination of the amounts of electric power for purchase and for sale, so that the electric power meter can transmit to the measuring center respective power information about the amounts of electric power for purchase and for sale as a group of separate power information, while sharing a single communication interface.

Thus, when configuring the remotely measurable electric power meter that is capable of measuring both the amounts of electric power for purchase and for sale, the amounts of electric power for purchase and for sale for each power consumer can be managed with high reliability. Further, when it is configured such that a target amount of electric power is selectively transmitted to the measuring center according to the determination of the amounts of electric power for purchase and for sale, it is possible to transmit at least that power information required for the remote measuring to be performed, because only the electric power information that is about the electric power to be measured is transmitted to the measuring center.

Further, the communication function may be implemented by power line communication wherein a power line is a communication medium.

With such configuration, the communication function is implemented via power line carrier communication, when the power information measured by the electric power meter is transmitted to the measuring center, there is no need to provide a separate communication path, and it is possible to secure a dedicated communication path using an existing communication medium.

Further, the electric power meter may be a unit-type electric power meter.

With such configuration, the electric power meter is a unit-type electric power meter, so that it is possible to modify the function of respective units constituting the electric power meter by replacing them with another. Thus, for example, it is possible to easily change the function of a power display having a single display screen to that of a power display having two separate display screens and vice-versa when the respective unit is replaced with another. Thus, the degree of freedom of the electric power meter can be further improved upon.

According to the electric power meter of the present invention, the plurality of pieces of power information about the amount of electric power for purchase or sale for respective power consumer can be reasonably measured by a unitary electric power meter.

### Brief Description of the Drawings

The objects and features of the present invention will be apparent from the following description of embodiments when taken in conjunction with the accompanying drawings, in which:
Fig. 1 is a block diagram of the schematic construction of a power supply system to which an electric power meter of the invention is applied;
Fig. 2 is a diagrammatic view showing the schematic construction of an electric power meter in accordance with a first embodiment of the invention;
Fig. 3 is a view showing the display type of power information using a power display used to display the amount of electric power for purchase and a power display used to display the amount of electric power for sale in accordance with the first embodiment of the electric power meter;
Fig. 4 is a block diagram of the schematic view of the electric power meter in accordance with the first embodiment;
Fig. 5 is a time chart showing a power information transmission procedure that uses the electric power meter in accordance with the first embodiment;
Fig. 6 is a diagrammatic view showing the schematic construction of an electric power meter in accordance with a second embodiment of the present invention;
Fig. 7 is a time chart showing a procedure of displaying the amount of electric power for purchase and sale using the electric power meter in accordance with the second embodiment;
Fig. 8A is a view showing a displayed example of the amount of electric power for sale which is displayed on a common power display, and Fig. 8B is a view showing an example of displaying the amount of electric power for purchase which is displayed on a common power display;
Fig. 9 is a diagrammatic view showing the schematic construction of an electric power meter in accordance with a third embodiment of the present invention; and
Fig. 10 is a block diagram showing the schematic construction of the electric power meter in accordance with the third embodiment.

### Detailed Description of the Preferred Embodiments

Reference will now be made in greater detail to exemplary embodiments of the invention with reference to the accompanying drawings which constitute a portion of this specification. The same reference numerals will be used throughout the drawings and the description to refer to the same or like parts, and overlapping descriptions thereof will be omitted.

### (First Embodiment)

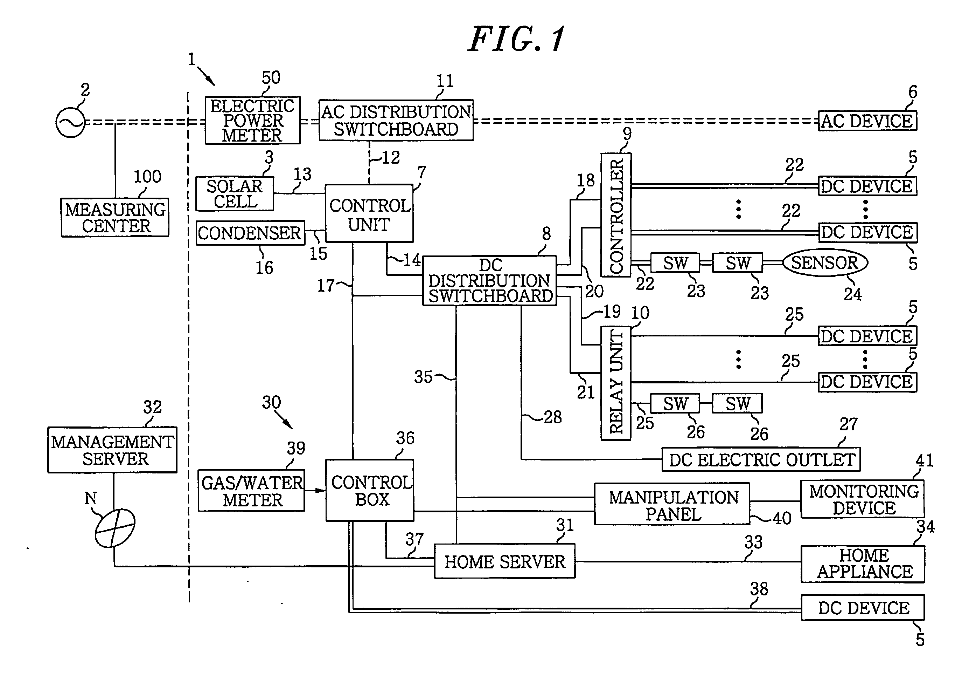

A power supply system to which an electric power meter of the present invention has been applied will now be described with reference to Fig. 1.

As shown in Fig. 1, a house (which is a power consumer) is provided with the power supply system 1 that supplies electric power to a variety of household appliances (lighting device, air conditioners, domestic appliances, audio video device, and the like.). The power supply system 1 uses a power source, such as a household alternating-current power supply (AC power source) 2 and a solar cell 3 that generates electricity by converting sunlight into electricity, in order to operate the diverse appliances. The power supply system 1 supplies electric power to a DC device 5 that operates under DC power supplied from a DC power supply (DC supply voltage), as well as an AC device 6 that operates under AC power from a supply voltage (AC supply voltage).

While the following embodiments have used a power supply system 1 mounted in a house by way of example for the sake of description, the present invention is not limited thereto, but the power supply system may be mounted and applied to a multi-residential house or apartment, the office, a factory, or the like.

The power supply system 1 is provided with a cabinet panel including a control unit 7 and a DC distribution switchboard 8 (including a DC breaker). In addition, the power supply system 1 is also provided with a controller 9 and a relay unit 10 to control the operation of the DC device 5 of the house.

The control unit 7 connects with an AC distribution switchboard 11 that distributes AC power, via an AC power line 12. The control unit 7 connects to the power supply 2 via the AC distribution switchboard 11 and also to the solar cell 3 via a DC power line 13. The control unit 7 receives AC power and DC power from the AC distribution switchboard 11 and the solar cell 3, respectively, and converts them into DC power to be the power source for an appliance. The control unit 7 outputs the converted DC power to the DC distribution switchboard 8 via a DC power line 14, or otherwise to a condenser 16 via a DC power line 15 to store the DC power therein.

It is also possible for the control unit 7 to receive AC power from the AC distribution switchboard 11, and to convert the power from the solar cell 3 or condenser 16 to AC power and supply it to the AC distribution switchboard 11 as well. The control unit 7 performs data communications with the DC distribution switchboard 8 via a signal line 17.

The DC distribution switchboard 8 is a kind of breaker that disposes of DC power. The DC distribution switchboard 8 allows DC power input from the control unit 7 to split, and outputs the split DC power to the controller 9 via a DC power line 18, or otherwise to the relay unit 10 via a DC power line 19. The DC distribution switchboard 8 performs data communications with the controller 9 via a signal line 20, or otherwise with the relay unit 10 via a signal line 21.

The controller 9 is connected to a plurality of DC devices 5. The DC devices 5 are connected with the controller 9 via a DC supply line 22 which carries both the DC power and data concurrently. The DC supply line 22 carries both the power and data to the DC device 5 via a pair of wires using DC overlapping communications in which a communications signal transmitting data with a high frequency carrier wave overlaps with the DC power that is a power source of the DC device. The controller 9 receives DC power for the DC device 5 via the DC power line 18 and checks the DC device 5 to be controlled and checks how to control the corresponding DC device 5 based on an operational command obtained via the signal line 20 from the DC distribution switchboard 8. The controller 9 outputs the DC power and operational command to the target DC device 5 via the DC supply line 22 to control the operation of the DC device 5.

The controller 9 is connected, via the DC supply line 22, to a switch 23 that is operated to switch the operation of the DC device 5. The controller 9 is connected, via the DC supply line 22, with a sensor 24 which detects a signal transmitted from, e.g., an infrared remote controller. Thus, the DC device 5 is controlled by a communications signal that flows over the DC supply line 22 by any of the operation of the switch 23, the detection of the sensor 24, as well as the operational command from the DC distribution switchboard 8.

The relay unit 10 is connected by separate DC power lines 25 to the plurality of DC devices 5. The relay unit 10 receives DC power for the DC device 5 via the DC power line 19 and checks the DC device 5 to be controlled based on an operational command obtained via the signal line 21 from the DC distribution switchboard 8. The relay unit 10 lets through or breaks the power supply from a built-in relay to the target DC device 5 via the DC power line 25 to control the operation of the DC device 5. Further, the relay unit 10 is connected to a plurality of switches 26 to manually control the DC device 5, so that the DC device 5 is controlled by the ON/OFF operation of the relay with respect to the power supply, which acts on the DC supply line 22 by the manipulation of the switches 26.

The DC distribution switchboard 8 is connected to a DC electric outlet 27 via a DC power line 28, wherein the DC electric outlet can be attached to a house in the form of, e.g., a wall outlet or bottom outlet. When a plug (not shown) of the DC device is inserted into the DC electric outlet 27, DC power can be directly supplied to the DC device.

An electric power meter 50 is connected to an electric power system located between the AC power supply 2 and the AC distribution switchboard 11. Here, the electric power meter 50 is capable of remotely measuring the amount of electric power for purchase, i.e. the wattage of electric power of the AC power supply 2, and the amount of excess electric power for sale, i.e. excess wattage for sale of electric power generated by the solar cell 3. The electric power meter 50 transmits the results of the measuring to a measuring center 100 that is a management center for the power information and located in a power supply company or the like, via, e.g., power line carrier communication or wireless communication.

The power supply system 1 is provided with a network system 30 that enables a variety of home appliances to be controlled via network communication. The network system 30 is provided with a home server 31 which is the control unit of the network system 30. The home server 31 is connected to an external management server 32 via a network N such as the Internet, and also with a home appliance 34 via a signal line 33. The home server 31 operated under the DC power, as a power source, obtained via a DC power line 35 from the DC distribution switchboard 8.

The home server 31 is connected to a control box 36 via a signal line 37. The control box 36 manages the operation control of diverse home appliances via network communication and can be connected to the control unit 7 and DC distribution switchboard 8 via the signal line 17, and directly control the DC device 5 via a DC supply line 38. The control box 36 is connected with e.g. a gas/water meter 39 that is capable of remotely measuring the amount of gas or water that is used, and also with a manipulation panel 40 of the network system 30. The manipulation panel 40 is connected to, e.g., a monitoring device 41 which includes a door phone extension unit, a sensor, or a camera.

When an operational command for a variety of home appliances is inputted via the network N, the home server 31 commands the control box 36 to operate the diverse appliances in conformity with the operational command. Further, the home server 31 can provide the management server 32 via the network N with a variety of information that is obtained from the gas/water meter 39. Further, when the home server 31 receives that the monitoring device 41 detects an abnormality detection from the manipulation panel 40, the home server 31 also provides the management server 32 with the corresponding information via the network N.

According to the electric power supply system, driving the variety of home appliances can be collectively managed by the home server 31, and electric power can be effectively supplied to the diverse appliances.

However, in order to remotely measure the amounts of electric power for purchase and sale for each power consumer, there is a need to provide in parallel a dedicated electric power meter for measuring the amount of electric power for purchase and another dedicated electric power meter for measuring the amount of electric power for sale. The amount of electric power for purchase or sale is the power information of merely one power consumer, so that it is unreasonable to separately provide the electric power meters for purchase and sale in order to obtain the power information of the respective consumer, and if this were the case, the wiring structures thereof would have to be complicated.

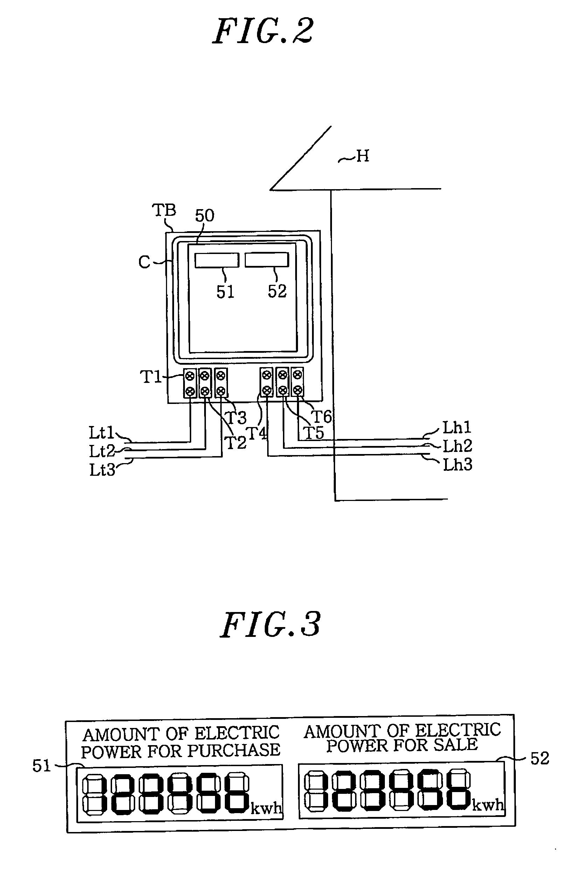

Thus, the present embodiment is configured to provide only one electric power meter 50 which separately measures the amounts of electric power for purchase and for sale by detecting the flow direction of power in the electric power system. Fig. 2 shows the schematic construction of the electric power meter 50 of the present embodiment.

As shown in Fig. 2, the electric power meter 50 is provided in each power consumer H which also functions as a power supplier. The electric power meter 50 is mounted to a terminal board (TB) that relays power lines Lt1 to Lt3 connected to a column type transformer which transforms electric power supplied from a power supply company or the like and supplies it to the respective power consumer H. The electric power meter 50 mounted to the terminal board (TB) is provided with, as a power display for displaying the amounts of electric power for purchase and for sale, which were separately measured, in a discriminative manner, a power display unit 51 for displaying the amount of electric power for purchase and a power display unit 52 for displaying the amount of electric power for sale.

The electric power meter 50 constructed as such is covered with a protective cover C that protects the electric power meter 50. The electric power meter 50 of the present embodiment is configured as an integral type electric power meter in which respective elements serving their functions of measuring or displaying the amount of electric power, or the power information communication function are integrally arranged.

The terminal board (TB) to which the electric power meter 50 is mounted is provided with connection terminals T1 to T3, which are connected input terminals of the electric power meter 50 by an internal wiring, and connection terminals T4 to T6, which are also connected to output terminals of the electric power meter 50 by the internal wiring of the terminal board (TB). The connection terminals T1 to T3 is connected with single-phase 3-wire power lines Lt1 to Lt3 which extend from the column type transformer. The single-phase 3-wire power lines Lt1 to Lt3 consist of power lines Lt1 and Lt3 which transmit electric powers having opposite phases of 100 V with respect to the ground, and a neutral power line Lt2 that is earthed to the ground. The connection terminals T4 to T6 of the terminal board (TB) respectively connect with power lines Lh1 to Lh3 connected to the distribution switchboard provided in the power consumer H.

Thus, when electric power is supplied to the distribution switchboard of the power consumer H via the column type transformer from the power supply company or the like, a power supply path is defined in the electric power meter 50 such that electric power from the transformer is supplied to the distribution switchboard of the power consumer H sequentially via the input terminal and output terminal of the electric power meter 50. In the meantime, when excess electric power that is generated by the solar cell 3 or the like provided in the power consumer H is to be sold to the power supply company or the like, a power supply path is defined in the electric power meter 50 such that excess electric power of the power consumer H inversely flows toward the column type transformer from the power consumer H sequentially via the output terminal and input terminal of the electric power meter 50.

According to the electric power meter 50 constructed as such, when electric power is supplied from the power supply company or the like to the power consumer H, the supplied power flows from the input terminal of the electric power meter 50. Then, the electric power meter measures the amount of electric power for purchase based on the direction of flow of the electric power. In the meantime, when excess electric power generated by the solar cell 3 or the like is sold to the power supply company or the like from the power consumer H, a target excess electric power to be sold reversely flows from the output terminal of the power consumer H toward the column type transformer, i.e. from the output terminal toward the input terminal of the electric power meter 50.

Then, the electric power meter measures the amount of electric power for sale based on the direction of flow of the electric power. Thus, the amounts of electric power for purchase and for sale for each power consumer H can be measured together, so that a plurality of pieces of power information such as the amounts of electric power for purchase and for sale can be reasonably measured by the unitary electric power meter. Then, the amounts of electric power for purchase and for sale of the power consumer H, which were measured by the electric power meter 50, are transmitted to the measuring center 100 via power line carrier communication using the power lines Lt1 to Lt3 as a communication medium.

In addition, as shown in Fig. 3, the amounts of electric power for purchase and for sale, which were measured by the electric power meter 50, are separately displayed by the power display unit 51 which displays the amount of electric power for purchase and the power display unit 52 which displays the amount of electric power for sale. In the present embodiment, the amounts of electric power for purchase and for sale, which were respectively measured by the electric power meter 50, are physically divided and displayed by the power display units 51 and 52 for displaying the amounts of electric power for purchase and for sale, so that the amounts of electric power can be separately displayed.

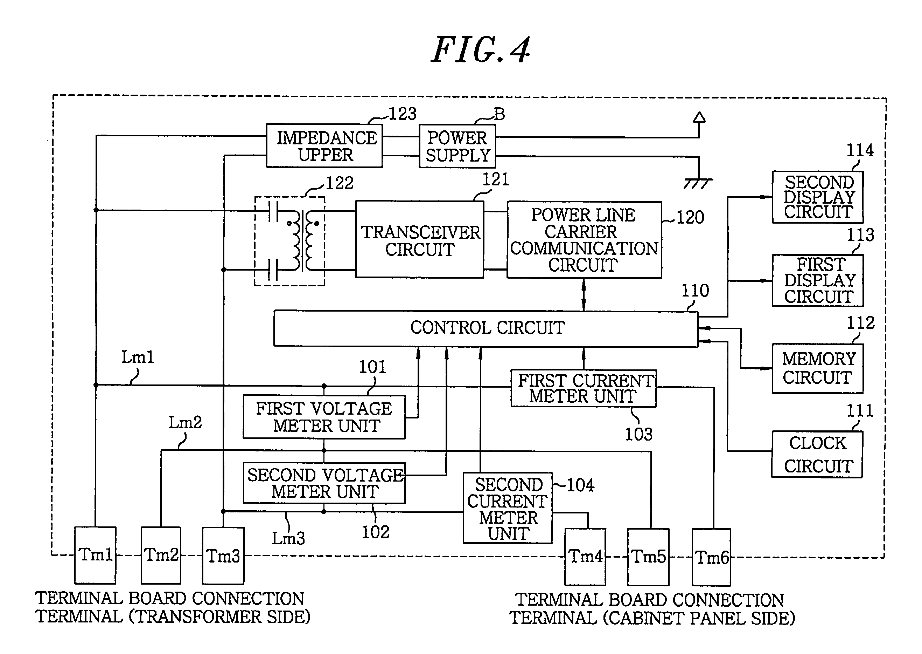

Next, the internal structure of the electric power meter 50 will be described with reference to Fig. 4. As shown in Fig. 4, the input terminals Tm1 to Tm3 constituting the electric power meter 50 are connected to the power lines Lt1 to Lt3 by internal wiring and the connection terminals T1 to T3 of the terminal board (TB). The supply power (electric power for purchase) input from the input terminals Tm1 to Tm3 is supplied to the distribution switchboard of the power consumer H along wiring paths Lm1 to Lm3 in the electric power meter 50, which respectively correspond to the power lines Lt1 to Lt3, sequentially via: the output terminals Tm4 to Tm6, the internal wiring of the terminal board (TB), the connection terminals T4 to T6, and the power lines Lh1 to Lh3 of the electric power meter 50.

In the meantime, the target excess power for sale (electric power for sale) generated by the solar cell 3 or the like is input from the output terminals Tm4 to Tm6 of the electric power meter 50 and is supplied toward the column type transformer from the power consumer H along wiring paths Lm1 to Lm3, sequentially via the input terminals Tm1 to Tm3, the internal wiring of the terminal board (TB), the connection terminals T1 to T3, and the power lines Lt1 to Lt3 of the electric power meter 50.

Further, the sets of magnitude and direction of voltage of the electric power for purchase and for sale are respectively measured by a first voltage meter unit 101, which is arranged between the wiring path Lm1 corresponding to the power line Lt1 and the wiring path Lm2 corresponding to the neutral power line Lt2, and a second voltage meter unit 102, which is arranged between the wiring path Lm2 corresponding to the neutral power line Lt2 and the wiring path Lm3 corresponding to the power line Lt3. In addition, the sets of the magnitude and direction of the current of the supply power are measured by a first current meter unit 103 arranged at the middle of the wiring path Lm1 and a second current meter unit 104 arranged at the middle of the wiring path Lm3.

The magnitudes and directions of voltage and current that were measured are used to calculate the amounts of electric power for purchase and for sale, and are input to a control circuit 110 that controls a display function or communication function using the power display units 51 and 52 which are resepcetively for displaying the amounts of electric power for purchase and for sale. The control circuit 110 determines whether the target electric power to be measured is electric power for purchase or electric power for sale based on the direction of input voltage or current. Under such determination, by multiplying the magnitudes of the respective input voltage and current, the amounts of electric power for purchase and for sale that are inputted to the electric power meter 50 are calculated. Then, the electric power is added up for a certain time period such as a day, a week, or a month, and the measuring time of the summed electric power, i.e. the measuring time of the amounts of electric power for purchase and for sale, is obtained from a clock circuit 111.

Then, power information about the electric power for purchase and for sale over a certain time period is separately stored in a memory circuit 112, together with the respective measuring time thereof. Then, the power information about the measured electric power for purchase is outputted to a first display circuit 113 which controls a display function of the power display unit 51, so that the power display unit 51 displays the power information about the electric power for purchase inputted to the first display circuit 113 in a manner shown in Fig. 3. In the meantime, the power information about the measured electric power for sale is outputted to a second display circuit 114 which controls a display function of the power display unit 52, so that the power display unit 52 displays the power information about the electric power for sale inputted to the second display circuit 114 in a manner shown in Fig. 3.

Then, the power information about the electric power for purchase and for sale calculated by the control circuit 110 is output from the control circuit 110 to a power line communication circuit 120. In the power line communication circuit 120, when the power information is transmitted, the power information input from the control circuit 110 is modulated to a PLC (power line communication) signal that overlaps the power lines Lt1 to Lt3 because the band of the power information is increased to a communication frequency band for power line carrier communication. The modulated PLC signal is outputted to a transceiver circuit 121 that adjusts the level of the signal or the like. In the meantime, when the PLC signal is received, the PLC signal inputted from the transceiver circuit 121 by the power line communication circuit 120 is demodulated.

Then, the PLC signal is inputted to a coupling circuit 122 via the transceiver circuit 121. The coupling circuit 122 functions as a filter that filters a frequency out of the frequency band of the PLC signal in the AC supply power supplied from a power source B which supplies AC power to the electric power meter 50. Generally, an input circuit of the power source B is connected to a condenser for preventing noise from being emitted to the outside, and the condenser decreases the impedance within a band of a communication frequency which is used in the power line carrier communication of the power line connected to the input circuit of the power source.

Thus, in the present embodiment, in order to carry out high efficiency power line carrier communication using the power line communication circuit 120, the transceiver circuit 121, and the coupling circuit 122, an impedance upper 123 for preventing reduction of impedance within a band of a communication frequency of the power line is provided between the power line and the power source B. Thus, the power source B can be connected to the input terminals Tm1 and Tm3 while restricting the reduction of impedance within the band of the communication frequency between the input terminals Tm1 and Tm3.

The PLC signal output from the coupling circuit 122 is transmitted to the measuring center 100 while being carried along the power lines Lt1 to Lt3.

Further, when transmitting the PLC signal, i.e. the power information, two types of information such as the electric power for purchase and electric power for sale are transmitted to the measuring center 100 from the unitary electric power meter 50. Because of this, in order for the measuring center 100, to which the two types of power information are transmitted, to manage the power information for purchase and the power information for sale of the power consumer H differently, it needs to transmit the two types of power information, measured by the electric power meter 50, in a discriminative manner.

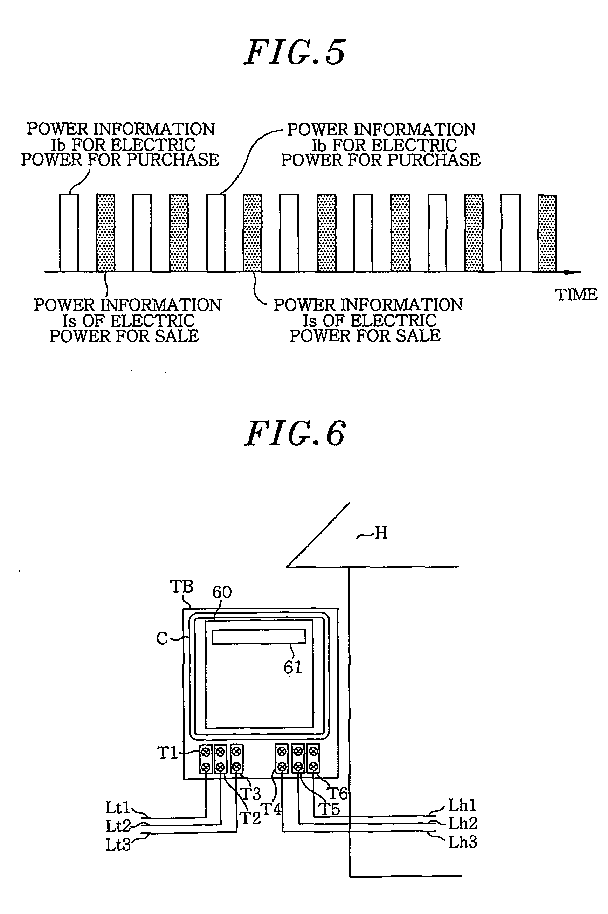

Thus, in the present embodiment, as shown in Fig. 5, the power information Ib for purchase and the power information Is for sale are alternately transmitted to the measuring center 100 in sequence. Thus, the electric power meter 50 can transmit respective power information Ib for purchase and power information Is for sale to the measuring center 100 in a discriminative manner based on a timing when the respective power information Ib and Is is transmitted, while sharing a single communication interface.

As previously described, according to the electric power meter of the present embodiment, the following effects can be obtained.
(1) The electric power meter is configured such that it detects the flow of power in the electric power system between the column type transformer and the distribution switchboard of the power consumer H and distinguishes between the amount of electric power for purchase and for sale on the basis of the detected direction of the flow of power, and separately measures the amounts of electric power for purchase and for sale. Thus, the amounts of electric power for purchase and for sale can be separately measured together by the electric power meter 50, so that a plurality of pieces of power information about a respective power consumer, such as the amounts of electric power for purchase and for sale, can be reasonably measured by a unitary electric power meter.
(2) The electric power meter is configured such that the power display displays the amounts of electric power for purchase and for sale, which were separately measured, in a discriminative manner and the power display is composed of two separate power display units 51 and 52 for displaying the amounts of electric power for purchase and for sale, respectively. Because of this, when the amounts of electric power for purchase and for sale are measured by the unitary electric power meter 50, the unitary electric power meter can display two kinds of power information such as the amounts of electric power for purchase and for sale, in a discriminative manner.
   Further, the power display is composed of the power display units 51 and 52 for displaying the amounts of electric power for purchase and for sale, so that the measured amounts of electric power for purchase and for sale, which were measured by the electric power meter 50, can be physically divided and separately displayed, and it is easy to discriminate between the amounts of electric power for purchase and for sale.
(3) The electric power meter is configured such that the power information Ib and Is for electric power for purchase and for sale, which was measured by the electric power meter 50, is alternately transmitted to the measuring center 100 in sequence. Thus, the electric power meter 50 can transmit respective power information Ib for purchase and power information Is for sale to the measuring center 100 in a discriminative manner based on timing when the respective power information Ib and Is is transmitted, while using a single communication interface. Thus, when configuring the remotely measurable electric power meter 50 that is capable of measuring both the amounts of electric power for purchase and for sale, the amounts of electric power for purchase and for sale in each power consumer H, which are transmitted from the electric power meter 50 to the measuring center 100, can be managed with high reliability.
(4) Communications between the electric power meter 50 and the measuring center 100 are implemented by of the electric power meter using power line carrier communication having power lines Lt1 to Lt3 as a communications medium. Thus, when the power information Ib and Is for electric power for purchase and for sale, measured by the electric power meter 50, is transmitted to the measuring center 100, there is no need to provide a separate communication path, but it is possible to secure a dedicated communications path using an existing communications medium.

### (Second Embodiment)

A second embodiment that embodies the electric power meter of the present invention will now be described with reference to Figs. 6 to 8B. The electric power meter of the second embodiment is configured such that the power display is composed of a single display screen, and other constructions thereof are the same as in the former embodiment.

Fig. 6 is a view corresponding to Fig. 2, which shows the schematic construction of an electric power meter 60 of the second embodiment. In Fig. 6, the same reference numerals are used to depict the same elements as those shown in Fig. 2, and overlapping descriptions thereof will be omitted.

That is to say, as shown in Fig. 6, the electric power meter 60 is configured such that the power display is composed of a single display screen having a common display section 61 on which both the amounts of electric power for purchase and for sale are displayed in common.

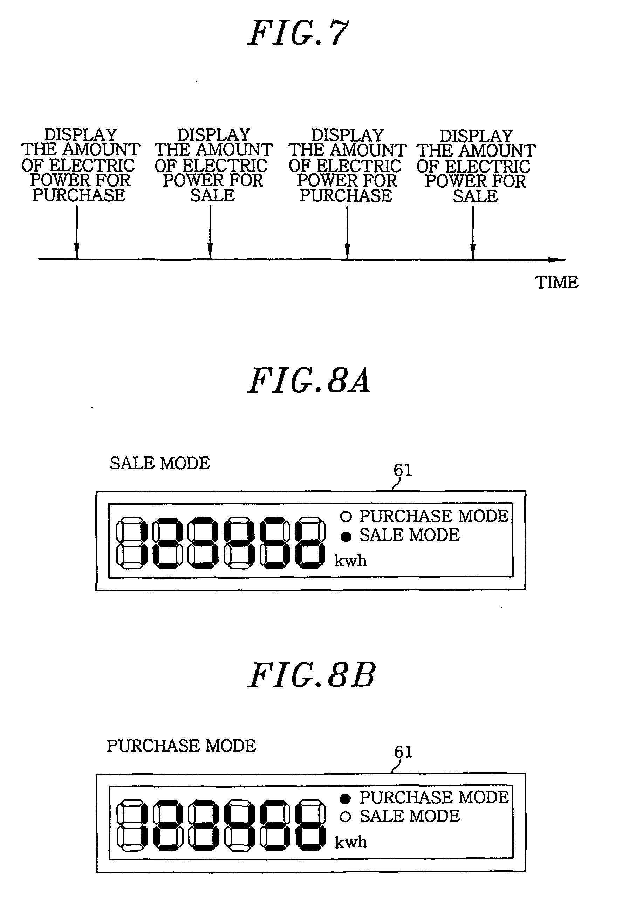

When the amounts of electric power of the power consumer for purchase and for sale were measured by the electric power meter 60, as shown in Fig. 7, the common display section 61 alternately displays both the amounts of electric power for purchase and for sale in a time-division manner.

When the amount of electric power for sale, which is generated by the solar cell 3 or the like of the power consumer H, is displayed, as shown in Fig. 8A, the common display section 61 displays information including an intent of sale and the amount of electric power to be sold. In the meantime, when the amount of electric power for purchase supplied from the power supply company or the like to the power consumer H is displayed, as shown in Fig. 8B, the common display section 61 displays information including an intent of purchase and the amount of electric power to be purchased. Thus, the amounts of electric power for purchase and for sale, which were measured by the electric power meter 60, can be displayed in a discriminative manner, using a common display section.

As previously described, according to the electric power meter of the embodiment, the effect similar to the effects (1), (3), and (4) can be obtained, and the following effects can also be obtained instead of the effect (2).
(5) It is configured such that the power display is composed of a single display screen having a common display section 61 on which both the amounts of electric power for purchase and for sale are displayed in common. Thus, when displaying both the amounts of electric power for purchase and for sale, which were measured by the electric power meter 60, in a discriminative manner, the structure of the power display can be simplified.
(6) It is configured such that the common display section 61 alternately displays the amounts of electric power for purchase and for sale in sequence. Thus, the variance in the amounts of electric power for purchase and for sale can be monitored.

### (Third Embodiment)

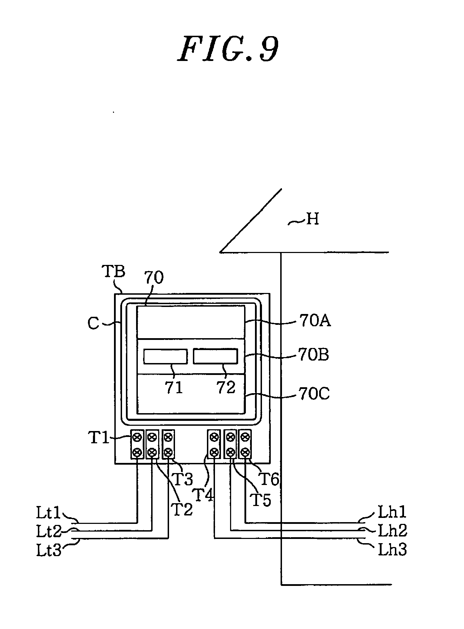

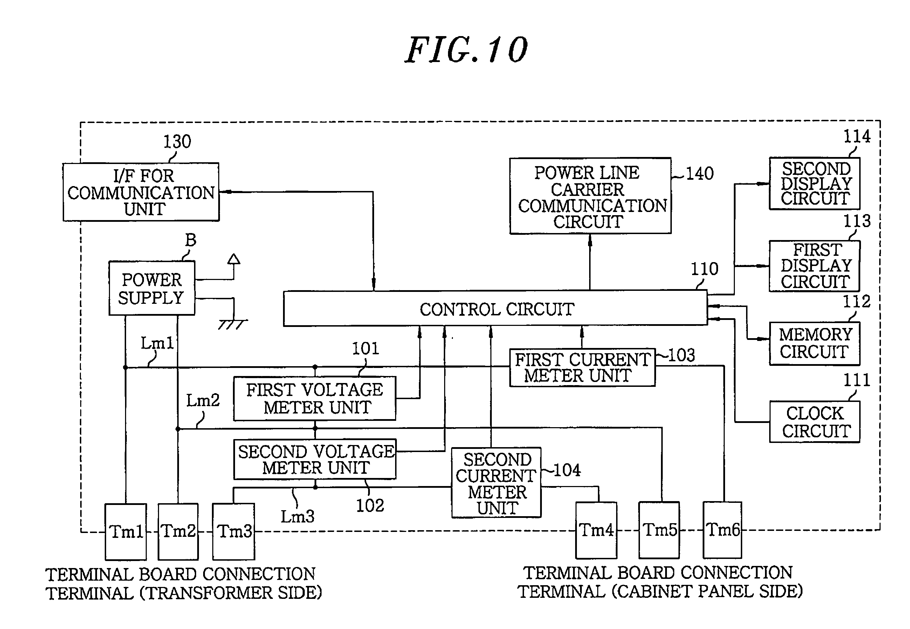

A third embodiment that embodies the electric power meter of the present invention will now be described with reference to Figs. 9 and 10. The electric power meter of the third embodiment is configured such that the electric power meter is a unit-type electric power meter, and the other constructions thereof are the same as in the former embodiment.

Fig. 9 is a view corresponding to Fig. 2, which shows the schematic construction of an electric power meter 70 of the third embodiment. In Fig. 9, the same reference numerals are used to depict the same elements as those shown in Fig. 2, and overlapping descriptions thereof will be omitted.

That is to say, as shown in Fig. 9, the electric power meter 70 is composed of three units including a communication unit 70A, a power metering unit 70B, and a load breaker unit 70C, which are mounted to the terminal board (TB). The power metering unit 70B detects the amounts of electric power for purchase and for sale based on the direction of the flow of power in the power system, and the detected amounts of electric power for purchase and for sale are displayed on power display units 71 and 72 which are for displaying the amounts of electric power for purchase and for sale and constitute the power display.

The communication unit 70A receives the amounts of electric power for purchase and for sale, which were measured by the power metering unit 70B, and transmits the received amounts of electric power for purchase and for sale to the measuring center 100 via power line carrier communication using the power lines Lt1 to Lt3 as a communications medium. Further, the power metering unit 70B receives a variety of types of information or control commands from the measuring center 100 or the like via the communication unit 70A.

Further, the load breaker unit 70C performs a breaking action depending on control commands from the power supply company or the like which are received by the power metering unit 70B. For example, when the power consumer H has moved in or out, the load breaker unit may perform power-feeding or power-breaking.

Next, the internal structure of the electric power meter 70 will be described with reference to Fig. 10. Fig. 10 is a view corresponding to Fig. 4, which shows the internal structure of the electric power meter 70 of the third embodiment. In Fig. 10, the same reference numerals are used to indicate the same elements as those shown in Fig. 4, and overlapping descriptions thereof will be omitted.

The power metering unit 70B of the electric power meter 70 includes a control circuit 110, a first and a second voltage meter unit 101 and 102, a first and a second current meter unit 103 and 104, a clock circuit 111, a memory circuit 112, and first and second display circuits 113 and 114, which are the same as those of Fig. 4, so descriptions thereof will be omitted.

That is to say, the electric power meter 70 is configured to further include an interface 130 for a communications unit which constitutes the communications unit 70A, and a breaker controller 140 which constitutes the load breaker unit 70C. The power information about the electric power for purchase and for sale input from the control circuit 110 via the interface 130 of the communications unit is transmitted to the measuring center 100 through a power line (not shown).

In addition, the interface 130 of the communication unit receives a variety of types of information or control commands from the measuring center 100 or the like, and outputs them to the control circuit 110. Meanwhile, the breaker controller 140 controls the load breaker unit 70C to perform a load breaking action depending on the control commands which are received by the interface 130 of the communication unit and input to the control circuit 110.

In the electric power meter 70, when the amounts of electric power of the power consumer H for purchase and for sale have been measured, the measured amounts of electric power for purchase and for sale are respectively displayed on the power display unit 71 and 72 which are for displaying the amounts of electric power for purchase and for sale. In addition, the amounts of electric power for purchase and for sale are alternately transmitted from the communication unit 70A to the measuring center 100 in sequence. Thus, the electric power meter 70 can concurrently measure the amounts of electric power of the power consumer H for purchase and for sale, and display and transmit the measured amounts of electric power for purchase and for sale in a discriminative manner.

As previously described, according to the electric power meter of the present embodiment, the effects similar to the effects (1) to (4) can be obtained, and the following effect can also be obtained.
(5) The electric power meter is configured such that the electric power meter is a unit-type electric power meter 70 that is capable of separately measuring the amounts of electric power for purchase and for sale based on the direction of the flow of power in the power system. Thus, although the communication means or display means of the electric power meter 70 may be changed and made different, such a situation can be flexibly dealt with by replacing the communication unit 70A, the power metering unit 70B, and the load breaker unit 70C, which constitute the electric power meter 70, thereby improving the degree of freedom of the electric power meter 70.

### (Other Embodiment)

The former embodiments may also be implemented as follows.

While the former embodiments are configured such that the power information Ib and Is for electric power for purchase and for sale, which was measured by the electric power meters 50 to 70, is alternately transmitted to the measuring center 100 in sequence, the present invention is not limited thereto, but may be configured such that it is determined whether the amount of electric power is for purchase or for sale, based on the direction of the flow of power in the power system, and the amount of power that is measured at that time is selectively transmitted to the measuring center 100 according to the determination. According to this construction, the electric power meter can transmit the power information Ib and Is about the electric power for purchase and for sale as a group of separate power information to the measuring center 100 while using a single communication interface in common.

Thus, when configuring the remotely measurable electric power meter that is capable of measuring both the amounts of electric power for purchase and for sale, the amounts of electric power for purchase and for sale of each power consumer can be managed with high reliability. When it is configured such that the amount of power that is to be measured is selectively transmitted to the measuring center 100 based on the determination of the amount of electric power for purchase or for sale, only the power information to be measured is transmitted to the measuring center 100, so that it is possible for the electric power meter to transmit at least the power information required for remote measuring to be performed.

While the former embodiments are configured such that the communications between the electric power meters 50 to 70 and the measuring center 100 is implemented via power line carrier communication having power lines Lt1 to Lt3 as a communications medium, the present invention is not limited thereto, and may be configured such that any communications medium between the electric power meters 50 to 70 and the measuring center 100 may be used so long as it can transmit the power information measured by the electric power meters 50 to 70 to the measuring center 100, and the communications between the electric power meters 50 to 70 and the measuring center 100 may be implemented using wireless communication or the like.

While the former embodiments are configured such that the electric power meters 50 to 70 have a communication function whereby the power information Ib and Is about electric power for purchase and for sale, which was separately measured, is automatically transmitted to the measuring center 100 that is the management center of the electric power meters, the present invention is not limited thereto, but may be configured such that when measuring the amounts of electric power of the power consumer H for purchase and for sale with a unitary electric power meter, the communications function of the electric power meters 50 to 70 is omitted.

While the second embodiment is configured such that the amounts of electric power for purchase and for sale are alternately displayed on the common display section 61 in a time-division manner, the present invention is not limited thereto, and may be configured such that it is determined whether the amount of electric power is for purchase or for sale, based on the direction of the flow of power in the power system, and the amount of power to be measured at that time according to the determination is selectively displayed on the common display section 61.

While the third embodiment is configured such that the power display constituting the electric power meter 70 is composed of two display units including the power display units 71 and 72 for displaying the amounts of electric power for purchase and for sale, the present invention is not limited thereto, and may be configured so that as shown in Figs. 6, 8A, and 8B, the power display is composed of a power display having a common display section on which both the amounts of electric power for purchase and for sale are displayed in common.

The first and third embodiments were configured such that the power display is composed of two display units including the power display units 51 and 71 for displaying the amount of electric power for purchase and the power display units 52 and 72 for displaying the amount of electric power for sale, and the second embodiment was such that the power display is composed of the power display having the common display section 61 on which both the amounts of electric power for purchase and for sale are displayed in common in a time-division manner.

However, the present invention is not limited thereto. Any power display may be used so long as it can display the amounts of electric power for purchase and for sale, which were measured by the electric power meter, in a discriminative manner. Further, when measuring the amounts of electric power for purchase and for sale using the unitary electric power meter, the electric power meter may include a power display which displays only one of the amount of electric power for purchase or the amount of electric power for sale.

While the invention has been shown and described with respect to the embodiments, the present invention is not limited thereto. It will be understood by those skilled in the art that various changes and modifications may be made without departing from the scope of the invention as defined in the following claims.

## Claims

1. An electric power meter separately measuring an amount of electric power for purchase supplied from an electric power system and an amount of electric power for sale which is generated by an electricity generation device,
wherein the electric power meter detects a power flow of the electric power system and separately measures the amount of electric power for purchase and the amount of electric power for sale while distinguishing between the amount of electric power for purchase and the amount of electric power for sale on the basis of a direction of the detected power flow.

2. The electric power meter according to claim 1, wherein the electric power meter is provided with a power display that displays the amount of electric power for purchase and the amount of electric power for sale, which were separately measured, in a discriminative manner.

3. The electric power meter according to claim 2, wherein the power display includes two separate display units that consist of a display unit which displays the amount of electric power for purchase and a display unit which displays the amount of electric power for sale.

4. The electric power meter according to claim 2, wherein the power display is composed of a single display screen having a common display section on which both the amount of electric power for purchase and the amount of electric power for sale are displayed in common.

5. The electric power meter according to claim 4, wherein the common display section of the power display displays the amount of electric power for purchase and the amount of electric power for sale in a time-division manner.

6. The electric power meter according to any one of claims 1 to 5, wherein the electric power meter has a communication function of automatically transmitting the amount of electric power for purchase and the amount of electric power for sale, which were separately measured, to a measuring center that is a management center of the electric power meter, in such a manner as to alternately transmit information about both the amounts of electric power for purchase and for sale to the measuring center in sequence.

7. The electric power meter according to any one of claims 1 to 5, wherein the electric power meter has a communication function of automatically transmitting the amount of electric power for purchase and the amount of electric power for sale, which were separately measured, to a measuring center that is a management center of the electric power meter, in such a manner as to selectively transmit to the measuring center a measured amount of electric power whenever determination is made whether the amount of electric power is for purchase or for sale.

8. The electric power meter according to claim 6 or 7, wherein the communication function is implemented by power line communication wherein a power line is a communication medium.

9. The electric power meter according to any one of claims 1 to 8, wherein the electric power meter is a unit-type electric power meter.
